(19) Europäisches Patentamt
European Patent Office
Office européen des brevets

(11) Publication number: **0 441 986 B1**

(12) # EUROPEAN PATENT SPECIFICATION

(45) Date of publication of patent specification: **13.12.95**

(51) Int. Cl.[6]: **C04B 35/00**, C01G 29/00, C01G 21/00, H01L 39/24

(21) Application number: **90913259.9**

(22) Date of filing: **05.09.90**

(86) International application number: **PCT/JP90/01139**

(87) International publication number: **WO 91/03426 (21.03.91 91/07)**

(54) **SUPERCONDUCTING MATERIAL AND PRODUCTION THEREOF**

(30) Priority: **05.09.89 JP 230876/89**
**27.09.89 JP 252830/89**
**30.10.89 JP 282700/89**
**29.03.90 JP 81834/90**

(43) Date of publication of application:
**21.08.91 Bulletin 91/34**

(45) Publication of the grant of the patent:
**13.12.95 Bulletin 95/50**

(84) Designated Contracting States:
**DE FR GB**

(56) References cited:
**EP-A- 0 368 765**
**JP-A- 1 252 538**
**JP-A- 1 290 530**
**JP-A- 1 317 125**

(73) Proprietor: **INTERNATIONAL SUPERCONDUCTIVITY TECHNOLOGY CENTER**
**No. 34-3, Shinbashi 5-chome**
**Minato-ku**
**Tokyo (JP)**

Proprietor: **SUMITOMO ELECTRIC INDUSTRIES, LTD.**
**5-33, Kitahama 4-chome,**
**Chuo-ku**
**Osaka-shi,**
**Osaka 541 (JP)**

Proprietor: **MATSUSHITA ELECTRIC INDUSTRIAL CO., LTD.**
**1006, Ohaza Kadoma**
**Kadoma-shi,**
**Osaka-fu, 571 (JP)**

(72) Inventor: **KANEKO, Tetuyuki**
**19-35, Midori-machi 5-chome**
**Koganei-shi**
**Tokyo 184 (JP)**
Inventor: **WADA, Takahiro**
**36-3, Amanogahara-cho 2-chome**
**Katano-shi**
**Osaka (JP)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.09/3.3.3)

Inventor: **YAMAUCHI, Hisao**
**6-304, Mihama 1-chome**
**Urayasu-shi**
**Chiba 279 (JP)**
Inventor: **TANAKA, Shoji**
**2-5-23, Kaga-cho**
**Shinjuku-ku**
**Tokyo 162 (JP)**
Inventor: **ADATI, Seiji**
**8-15-401, Kitasakae 3-chome**
**Urayusu-shi**
**Chiba-ken (JP)**
Inventor: **ICHIKAWA, Yo**
**Shalon Shirokita 201**
**2-107, Dainichi-cho**
**Moriguchi-shi**
**Osaka 570 (JP)**
Inventor: **HIGASHINO, Hidetaka**
**A-2-505, 117, Hitotsuya-cho**
**Matsubara-shi**
**Osaka 580 (JP)**

(74) Representative: **Allam, Peter Clerk et al**
**LLOYD WISE, TREGEAR & CO.**
**Norman House**
**105-109 Strand**
**London WC2R 0AE (GB)**

## Description

The present invention relates to a superconductive material of oxides having a superconductivity transition initiating temperature (Tc) which can be as high as 100-125K, and to a process for producing same.

Since a superconductive oxide material of La-Ba-Cu-O series having a critical temperature as high as 30K was discovered in 1936, superconductive materials of oxides have drawn public attention. In 1987, it was confirmed that a superconductive oxide of Y-Ba-Cu-O series had a critical temperature of about 90K which is higher than the temperature of liquefied nitrogen (77K). In 1988, superconductive materials of Bi-Sr-Ca-Cu-O series and Tl-Ba-Ca-Cu-O series were discovered and the critical temperature was raised to 100K or higher. Since then, active studies have been carried out to develop superconductive materials $Tl_2Ba_2Ca_2Cu_3O_{10}$ (Tc:125K), $TlBa_2Ca_3Cu_4O_{11}$ (Tc:122K), $Tl_{0.5}Pb_{0.5}Sr_2Ca_2Cu_3O_9$ (Tc: 122K), etc. [Koh-ichi Kitazawa and Kohji Kishio, Applied Physics vol. 57, pp.1644-1655 (1988)].

However, superconductive materials in the prior art, such as those of Tl-Ba-Ca-Cu-O series and of Tl-Pb-Sr-Ca-Cu-0 series, involve problems such that the high content of Tl can be harmful to the human body, and that in their manufacture evaporation of Tl takes place by baking so that the production of the superconductive materials cannot be made with good reproducibility or the production is limited.

It is the object of the present invention to provide a novel superconductive material of oxides which can have a Tc as high as 110-125K, as well as a process for producing same with good reproducibility and in a simple manner.

In accordance with the present invention, there is provided a superconductive material characterized by having a crystalline phase comprised of oxides of the chemical composition:

$Tl_xPb_yBi_zSr_2Ca_2Cu_3O_r$ (I)

wherein x, y and z are numbers satisfying the following formulae:

$$x+y+z = 1$$
$$0.3 \leqq x \leqq 0.95$$
$$0 \leqq y \leqq 0.5$$
$$0.05 \leqq z \leqq 0.4$$

and r is a number of approximately 9.

In accordance with the present invention, there is also provided a suprconductive material having a crystalline phase comprised of oxides of the chemical composition:

$(Tl_{1-x-y}Bi_xPb_y)_1Sr_2Ca_3Cu_4O_z$ (II)

wherein x and y are numbers satisfying the following formulae:

$$0.05 \leqq x \leqq 0.55$$
$$0 \leqq y \leqq 0.55$$
$$x+y \leqq 0.65$$

and z is any desired number.

In accordance with the present invention, there is further provided a process for the production of a superconductive material having a crystalline phase comprised of oxides of the chemical composition:

$Tl_xPb_yBi_zSr_2Ca_2Cu_3O_r$ (I)

wherein x, y and z are numbers satisfying the following formulae:

$$x+y+z = l$$
$$0.3 \leqq x \leqq 0.95$$
$$0 \leqq y \leqq 0.5$$
$$0.05 \leqq z \leqq 0.4$$

and r is a number of approximately 9,

characterized in that a mixture containing at least Tl, Bi, Sr, Ca, Cu and O and, if necessary, Pb wherein the atomic ratio of Tl:Pb:Bi:Sr:Ca:Cu is x:y:z:2:2:3 where x, y and z have the same meanings as given above, is baked in an oxygen atmosphere, the partial pressure of which is preferably at least $1.013 \times 10^5$ Pa (1 atm.).

In accordance with the present invention, there is still further provided a process for the production of a superconductive material having a crystalline phase comprised of oxides of the chemical composition:

$Tl_xPb_yBi_zSr_2Ca_2Cu_3O_r$ (II)

wherein x, y and z are numbers satisfying the following formulae:

$$x + y + z = 1$$
$$0.3 \leqq x \leqq 0.95$$
$$0 \leqq y \leqq 0.5$$
$$0.05 \leqq z \leqq 0.4$$

and r is a number of approximately 9,
characterized in that a mixture containing at least Tl, Bi, Sr, Ca, Cu and O, if necessary, Pb wherein the atomic ratio of Tl:Pb:Bi:Sr:Ca:Cu is x:y:z:2:2 + p:3 + q where x, y and z have the meanings as given above, p and q are numbers satisfying the formulas $0 < p \leqq 1.5$ and $0 < q \leqq 1.5$, respectively, is baked at 900 - 950 °C and thereafter annealing the resultant baked product for at least one hour at a temperature of 400 - 900 °C.

In the superconductive material according to this invention having a crystalline phase comprised of oxides represented by the above chemical composition (I), it is preferred that x, y and z satisfy the formulae: $0.35 \leqq x \leqq 0.9$, $0 \leqq y \leqq 0.45$ and $0.05 \leqq z \leqq 0.2$. When, in this superconductive material, y is a number satisfying the formula $O \leqq y \leqq 0.4$ and the ratio of x to z is 4:1, a superconductive material of oxides having the highest critical temperature can be obtained.

The superconductive materials having a crystalline phase comprised of oxides represented by the chemical compositions (I) and (II) according to this invention have the merit that their Tc can be as high as 110-125K but their content of harmful Tl is small. Further, they contain Bi which inhibits evaporation of Tl on baking so that the superconductive materials can be made with good reproducibility.

As the starting compounds of the superconductive materials of this invention there are used thallium compounds, lead compounds, bismuth compounds, strontium compounds, calcium compounds and copper compounds. The use of the lead compounds may be omitted if necessary. Each starting compound may be in the form of an oxide, a hydroxide, a carbonate or a nitrate.

The process for the production of the superconductive materials of this invention includes the step of forming a mixture containing elements of at least Tl, Bi, Sr, Ca and Cu, and if necessary Pb, and the step of baking the mixture to form a crystalline phase comprised of superconductive oxides. As the method for forming the mixture there may be adopted, for example, a method wherein all of the starting compounds are mixed homogeneously at a time, a method wherein a portion of the starting compounds is previously mixed homogeneously and then the remaining starting compounds are added and mixed homogeneously, and a method for previously mixing a part of the starting compound, baking the mixture in oxygen atmosphere, pulverizing the baked product and admixing the pulverized product with the remaining starting compounds.

In order to prepare a superconductive material having a crystalline phase comprised of oxides represented by the chemical composition (I) in a preferred manner, a mixture containing a calcium compound and a copper compound in excess of the atomic ratio represented by the chemical composition (I) is formed first. Thus, a mixture is obtained wherein the atomic ratio of Tl:Pb:Bi:Sr:Ca:Cu is x:y:z:2:2 + p:3 + q. In this case, x, y and z are numbers satisfying the formulae: $x + y + z = 1$, $0.3 \leqq x \leqq 0.95$, $0 \leqq y \leqq 0.5$ and $0.05 \leqq z \leqq 0.4$, and p and q are numbers satisfying the formulae: $0 < p \leqq 1.5$ and $0 < q \leqq 1.5$, respectively.

The mixture is then baked at 900-950 °C, and the resultant baked product is annealed at 400-900 °C.

According to one preferred process for producing superconductive materials having a crystalline phase comprised of oxides represented by the chemical composition (I), a bismuth compound, a strontium compound, a calcium compound, a copper compound and, if necessary, a lead compound are mixed first so that the atomic ratio of Pb:Bi:Sr:Ca:Cu is y:z:2:2 + p:3 + q, and then the mixture is baked at 750-900 °C in an oxygen atmosphere. The resultant baked product is then well pulverized and a thallium compound is added thereto and well mixed so that the atomic ratio may become a proportion of x. The mixture is sintered at 900-950 °C in oxygen atmosphere and the resultant baked product is annealed at 400-900 °C.

According to another preferred process for producing superconductive materials having a crystalline phase comprised of oxides represented by the chemical composition (I), a bismuth compound, a strontium compound, a calcium compound and, if necessary, a lead compound are mixed first so that the atomic ratio of Pb:Bi:Sr:Ca:Cu is y:z:2:2:3, and then the mixture is baked at 750-900°C in oxygen atmosphere. The resultant baked product is sufficiently pulverized and a thallium compound is added thereto and well mixed so that the atomic ratio may become a proportion of x. This mixture is then baked at 800-1000°C, preferably 900-950°C and the baked product is pulverized. A calcium compound and a copper compound is added to the pulverized product so that their atomic ratios may become 2+p and 3+q, respectively, and well mixed. The mixture is baked at 900-950°C in oxygen atmosphere and the resultant baked product is annealed at 400-900°C in an oxygen atmoshere.

In order to prepare a superconductive material having a crystalline phase comprised of oxides represented by the chemical composition (II) in a preferred manner, a strontium compound, a calcium compound and a copper compound are mixed firstly so that the atomic ratio of Sr:Ca:Cu may become 2:3:4, and the mixture is baked at 700-900°C in oxygen atmosphere. A thallium compound, a bismuth compound and, if necessary, a lead compound are added to the resultant baked product so that the atomic ratio of Tl:Bi:Pb may become 1-x-y:x:y, and well mixed. The mixture is baked at 850-1000°C, preferably 900-950°C. In this case, the above mentioned x, y and z are numbers satisfying the formulae: $0.05 \leqq x \leqq 0.55$, $0 \leqq y \leqq 0.55$ and $x+y \leqq 0.65$

The present invention will now be illustrated in more detail by way of Examples, and with reference to the accompanying drawings, in which:

Fig. 1 is a drawing showing the rsistance-temperature characteristics of No.7 sample in Example l.

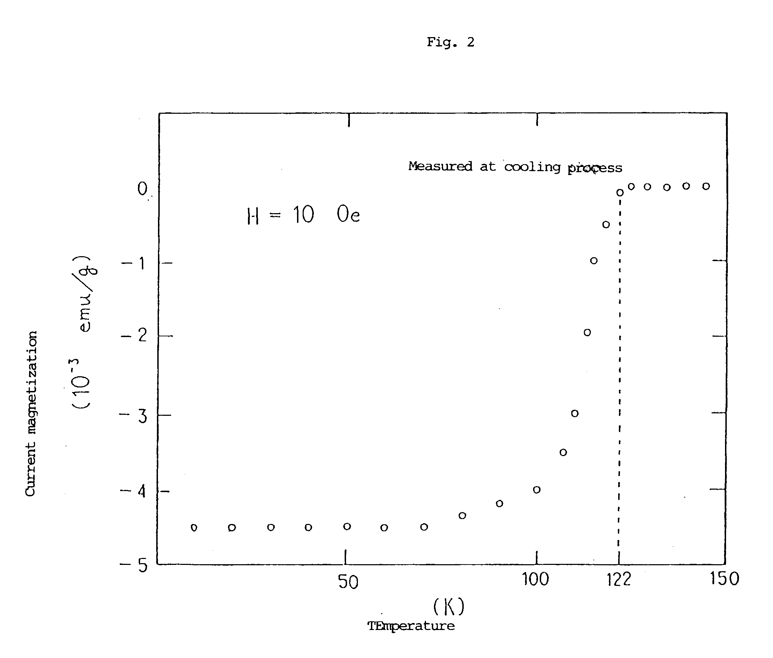

Fig. 2 is a drawing showing the direct current magnetization-temperature characteristics of No.7 sample in Example 1.

Fig. 3 is a powder X-rays diffraction pattern of No.7 sample in Example l.

Fig. 4 is a drawing showing the resistance-temperature characteristics of the samples synthesized in Examples 3 and 4 and the sample synthesized for the purpose of comparison.

Fig. 5 is a drawing showing the direct current magnetization-temperature characteristics of the samples synthesized in Examples 3 and 4 and the sample synthesized for the purpose of comparison.

Figs. 6A and 6C are drawings showing the resistance-temperature characteristics of the samples synthesized in Examples 3 and 4, respectively. Fig. 6B is a drawing showing the resistance-temperature characteristics of the sample synthesized for the purpose of comparison.

Fig. 7 is a drawing showing the resistance-temperature characteristics of the samples synthesized in Examples 7 and 8 and the sample synthesized for the purpose of comparison.

Fig. 8 is a drawing showing the direct current magnetization-temperature characteristics of the samples synthesized in Examples 7 and 8 and the sample synthesized for the purpose of comparison.

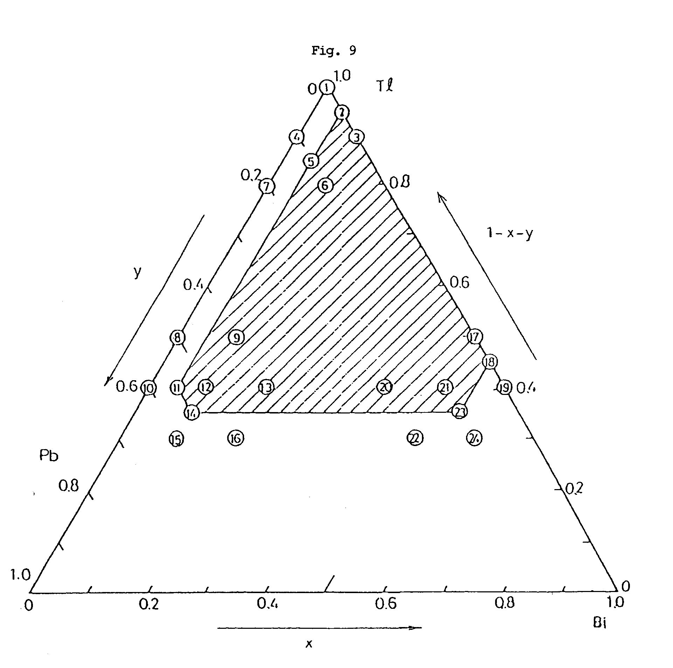

Fig. 9 is a drawing showing the composition of Tl, Bi and Pb of the sample prepared in Example 11.

Example 1

Using commercially available reagents as the starting materials, the samples having the compositions as shown in Table 1 were produced. A process for producing the samples will be illustrated, taking the case of sample No. 7 as an example.

As the starting materials were used commercially available $Tl_2 1_3$,PbO, $Bi_2O_3$, $SrCO_3$, $CaCO_3$ and CuO. The starting materials of Pb, Bi, Sr, Ca and Cu were firstly mixed well so that the proportion aimed at might be obtained. This powdery mixture was calcined at 850°C for 10 hours in oxygen atmosphere. The resultant calcined powder was sufficiently pulverized and admixed with a given proportion of $Tl_2O_3$ and well mixed. The mixed powder was press molded to form a rectangular parallelo-piped of 2 mm × 2 mm × 20 mm, sealed in a metal pipe, sintered at 900-950°C for 1-50 hours in oxygen atmosphere and cooled in a furnace.

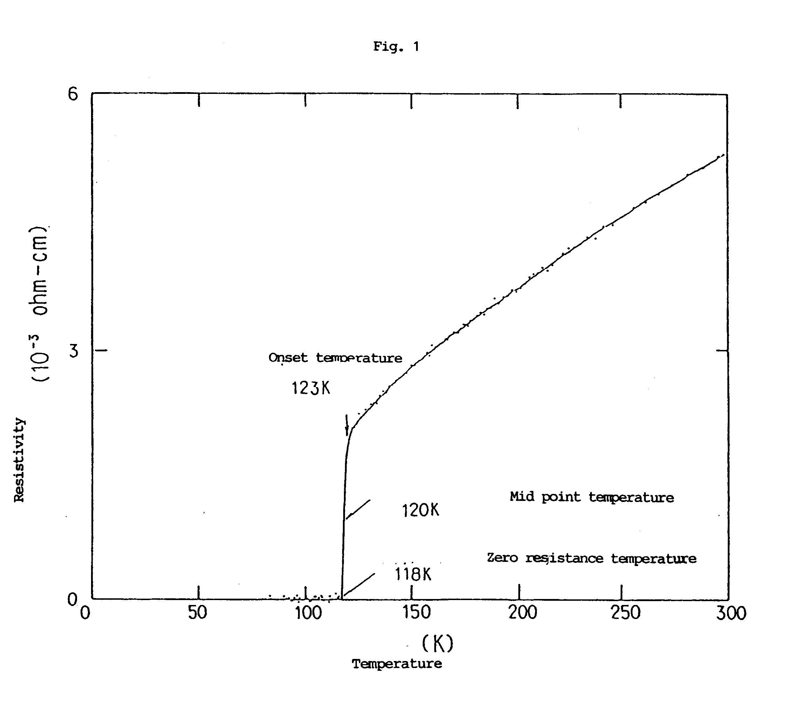

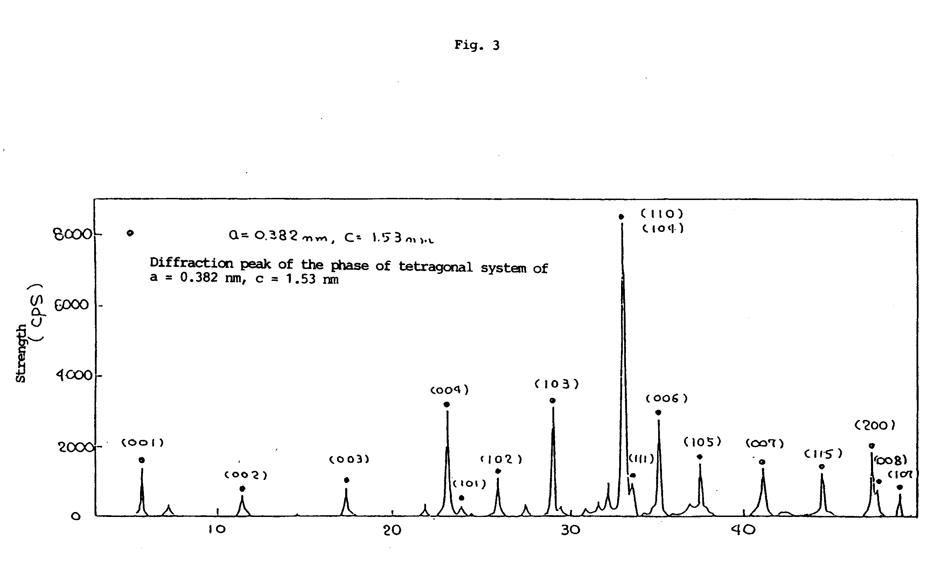

The sample was then taken out from the furnace and the resistance-temperature characteristics of the sample was measured according to a usual 4-terminal method. A result of the measurement is shown in Fig. 1. The superconductivity initiating temperature (Tc) of this sample was 123K and a temperature at which the ratio of resistance is zero was 118K. The direct current magnetization rate of this sample was measured and a result of the measurement is shown in Fig. 3. This sample began to show a diamagnetic signal from 122K. The magnitude of the diamagnetic signal was about 30% of the entire diamagnetism at 5K.

Table 2 shows the superconductive characteristics of the samples having the compositions shown in Table 1. In Table 2, the term "onset temperature" means, as shown in Fig. 1, the superconductivity transition initiating temperature of the sample, i.e. a temperature at which the electric resistance of the sample begins to drop promptly. The term "mid point temperature" means the resistance value of the sample becomes half of the resistance value at the onset temperature. The term "zero resistance temperature" means the electric resistance of the sample being zero in the state of superconductivity.

From the result of Table 2, it is understood that a good superconductive material having a critical temperature (mid point temperature) exceeding 110K is obtained when x, y and z exist within the range of $0.35 \leqq x \leqq 0.95$, $0 \leqq y \leqq 0.5$ and $0.05 \leqq z \leqq 0.4$, respectively.

In particular, a superconductive material excellent in characteristics having a critical temperature (mid point temperature) exceeding 115K can be produced when x, y and z exist within the range of $0.35 \leqq x \leqq 0.9$, $0 \leqq y \leqq 0.45$ and $0.05 \leqq z \leqq 0.2$, respectively.

It is also understood that a superconductive material having a critical temperature (mid point temperature) of about 120K and a zero resistance temperature higher than 110K can be synthesized when the composition is such that y exists within the range of $0 \leqq y \leqq 0.4$ and the ratio of x to z is 4:1.

The sample of No.7 was subjected to powder X-ray diffraction analysis to investigate the composition thereof, a result of which is shown in Fig. 3. It is indexed out that a main peak of this X-ray diffraction pattern shows a unit lattice of a lattice constant a = 0.382 nm and a tetragonal system of c = 1.53 nm. Accordingly, it is noted that this superconductive oxide has a crystalline structure similar to that of $TlBa_2Ca_2Cu_3O_r$ ($r \approx 9$)(Hideo Ihara, Applied Physics vol.5, pp. 744-755).

Example 2

A sample having the composition same as that of the sample No.7 in Example 1 was sealed in a metal pipe and sintered for 10 hours at 900-950 °C in various partial pressures of oxygen atmosphere. This result is shown in Table 3. In view of the result, it is understood that as the partial pressure of oxygen becomes higher, both the mid point and the zero resistance temperature are elevated.

Table 1

| Sample No. | Composition | | | | | |
|---|---|---|---|---|---|---|
| | Tl (x) | Pb (y) | Bi (z) | Sr | Ca | Cu |
| 1 | 0.8 | 0.2 | 0 | 2 | 2 | 3 |
| 2 | 0.75 | 0.2 | 0.05 | 2 | 2 | 3 |
| 3 | 0.5 | 0.45 | 0.05 | 2 | 2 | 3 |
| 4 | 0.9 | 0 | 0.1 | 2 | 2 | 3 |
| 5 | 0.8 | 0 | 0.2 | 2 | 2 | 3 |
| 6 | 0.64 | 0.2 | 0.16 | 2 | 2 | 3 |
| 7 | 0.48 | 0.4 | 0.12 | 2 | 2 | 3 |
| 8 | 0.4 | 0.5 | 0.1 | 2 | 2 | 3 |
| 9 | 0.6 | 0 | 0.4 | 2 | 2 | 3 |
| 10 | 0.48 | 0.2 | 0.32 | 2 | 2 | 3 |
| 11 | 0.35 | 0.4 | 0.22 | 2 | 2 | 3 |
| 12 | 0.4 | 0.2 | 0.4 | 2 | 2 | 3 |

Table 2

| Sample No. | Onset temperature (K) | Mid Point temperature (K) | Zero resistance temperature (K) |
|---|---|---|---|
| 1 | 105 | 100 | 70 |
| 2 | 120 | 115 | 80 |
| 3 | 121 | 116 | 75 |
| 4 | 123 | 120 | 90 |
| 5 | 123 | 120 | 112 |
| 6 | 123 | 120 | 117 |
| 7 | 123 | 120 | 118 |
| 8 | 120 | 112 | 77 |
| 9 | 123 | 118 | 80 |
| 10 | 120 | 118 | 97 |
| 11 | 124 | 117 | 85 |
| 12 | 118 | 116 | 90 |

Table 3

| Partial pressure of oxygen (atm) | Onset temperature (K) | Mid point temperature (K) | Zero resistance temperature (K) |
|---|---|---|---|
| 2 | 124 | 121 | 119 |
| 5 | 125 | 122 | 120 |
| 10 | 127 | 125 | 122 |
| 20 | 127 | 126 | 124 |
| 50 | 130 | 127 | 125 |

Example 3

Commercially available materials of high purity, i.e. $Tl_2O_3$ , PbO, $Bi_2O_3$, $SrCO_3$, $CaCO_3$ and CuO were used as the starting materials for producing samples. First of all, PbO, $Bi_2O_3$, $SrCO_3$, $CaCO_3$ and CuO were weighed so as to correspond in proportion to $Pb_{0.2}Bi_{0.16}Sr_2Ca_3Cu_4$, and well mixed. This mixed powder was pressed and calcined at 850°C for 10 hours in oxygen atmosphere. The calcined product was well pulverized and $Tl_2O_3$ was added thereto so that the composition might become $Tl_{0.64}Pb_{0.2}Bi_{0.16}Sr_2Ca_3Cu_4$ and the whole was well mixed. This mixed powder was press molded to form a rectangular parallelo-piped of 2 mm × 2 mm × 20 mm, sealed in a metal pipe, sintered at 900-950°C for 20 hours in oxygen atmosphere and then cooled in a furnace. The resultant sample was annealed at 600°C for 20 hours, at 500°C for 20 hours and then at 400°C for 20 hours in oxygen atmosphere. The sample was then taken out from the furnace and measured for its resistance-temperature characteristics according to a usual 4 terminal method.

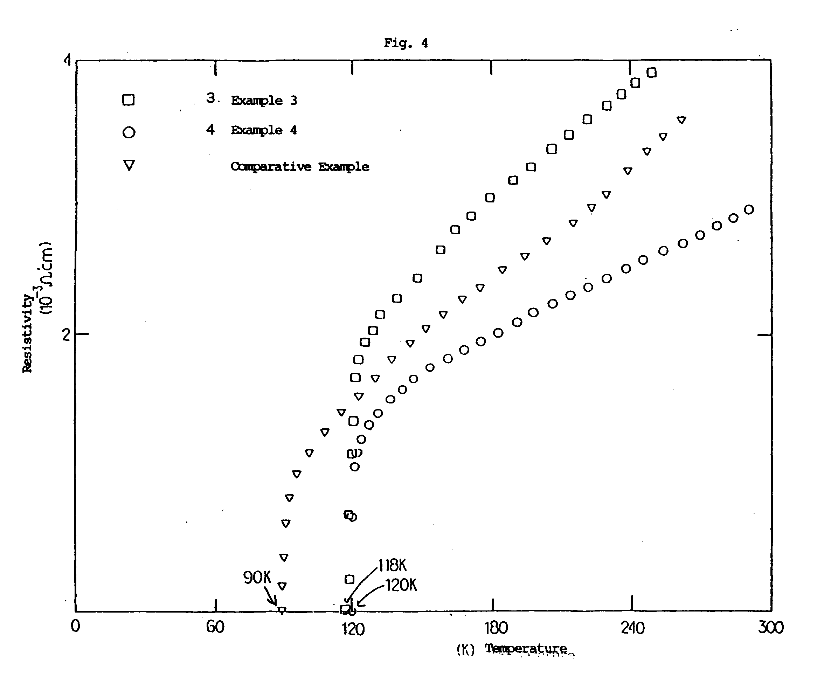

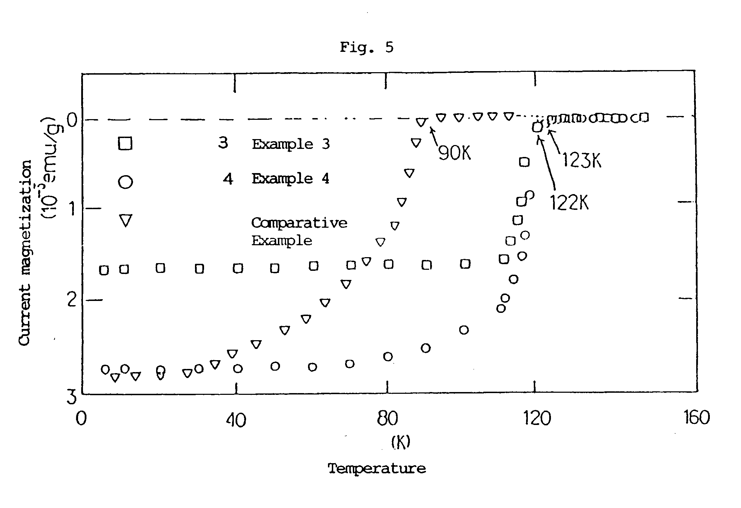

Fig. 4 shows the result of the measurement. The superconductivity initiation temperature of this sample was 123K and its resistance "0" temperature was 118K. The direct current magnetization was measured and the result is shown in Fig. 5. This sample began to show a diamagnetic signal from 122K. As shown in Fig. 3, the magnitude of the diamagnetic signal was about 12% of the complete diamagnetism at 5K.

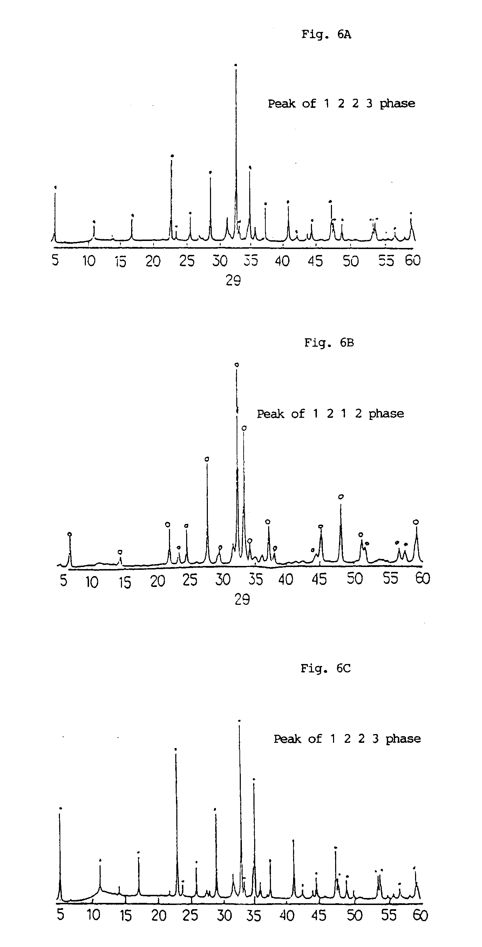

Fig. 6A shows a powder X-ray diffraction pattern of the sample produced according to the above process, measured by the aid of an X-ray diffraction apparatus using Cu-Kα rays as beam source. From the peaks it is understood that the sample is a cystal which comprises $(Tl,Pb,Bi)Sr_2Ca_2Cu_3O_w$ having a lattice constant a=0.38 nm and c=1.5 nm with w being a number of approximately 9. For the purpose of comparison, a sample comprised of a mixture of the composition $Tl_{0.64}Pb_{0.2}Bi_{0.16}Sr_2Ca_2Cu_3$ was synthesized according to the same process. The resistance-temperature characteristics, the direct current magnetization and the powder X-ray diffraction pattern measured by an X-ray diffraction apparatus using Cu-Kα rays as beam source of this sample are shown in Figs. 4, 5 and 6B, respectively. The critical temperature of this sample for comparison was about 90K. From the powder X-ray diffraction pattern, it is understood that the produced crystalline phase was not $(Tl,PB,Bi)Sr_2Ca_2Cu_3O_w$ but a phase of $(Tl,Pb,Bi)Sr_2CaCu_2O_7$. This reveals that the phase $(Tl,Pb,Bi)Sr_2Ca_2Cu_3O_9$ is hardly produced but the phase $(Tl,Pb,Bi)Sr_2CaCu_2O_7$ is easily produced from a mixture having a composition $(Tl,Pb,Bi)Sr_2Ca_2Cu_3$.

In view of the above, it is understood that the 1223 phase is easily produced from a mixture having a composition to which Ca and Cu are added excessively.

Example 4

The process illustrated in this Example is as follows:

(1) As in Example 3, commercially available $Tl_20_3$, PbO, $Bi_2O_3$, $SrCO_3$, $CaCO_3$, CaO and CuO of high purity were used as the starting mateials. First of all, PbO, $Bi_2O_3$, $SrCO_3$, $CaCO_3$ and CuO were weighed in proportion to $Pb_{0.2}Bi_{0.16}Sr_2Ca_2Cu_3$ and well mixed. This mixed powder was pressed and calcined at 850 °C for 10 hours in oxygen atmosphere.

(2) The resultant calcined product was well pulverized and $Tl_2O_3$ was added thereto so that the composition might become $Tl_{0.64}Pb_{0.2}Bi_{0.16}Sr_2Ca_2Cu_3$ and the whole was well mixed. This mixed powder was press molded to form a rectangular parallelo-piped of 2 mm × 2 mm × 20 mm, sealed in a metal pipe, sintered at 900-950 °C for 20 hours in oxygen atmosphre, and cooled in a furnace.

(3) This sintered product was pulverized again and powdery CaO and CuO were added thereto so that the composition might become $Tl_{0.64}Pb_{0.2}Bi_{0.16}Sr_2Ca_3Cu_4$, and the whole was well mixed. This mixed powder was again press molded, sealed in a metal pipe and sintered at 920 °C for 10 hours in oxygen atmosphere.

(4) After cooling the furnace, the sample was annealed at 600 °C for 20 hours, at 500 °C for 20 hours and then at 400 °C for 20 hours in oxygen atmosphere.

The sample was then taken out from the furnace and meassured for its resistance-temperature characteristics according to a usual 4 terminal method.

Fig. 4 shows the result of the measurement. The superconductivity initiation temperature of this sample was 125K and its resistence "0" temperature was 120K. As shown in Fig. 5, this sample began to show a diamagnetic signal from 123K. The magnitude of the diamagnetic signal was about 20% of the complete diamagnetism at 5K.

In comparison of the characteristics of the sample in Example 4 with those of the sample in Example 3, the sample of Example 4 is higher in the resistance "0" temperature by 2K. In case of the direct current magnetization, no significant difference is found between them in the temperature at which diamagnetism is initiated. However, the sample in Example 4 is about 2 times as much as the sample in Example 3 in the magnitude of the diamagnetic signal at 5K.

As is evident from the peak of X-ray diffraction pattern in Fig. 6C, it is noted that the superconductive oxide material in Example 4 has a phase of $(Tl,Pb,Bi)Sr_2Ca_2Cu_3O_w$ similar to the sample in Example 3 wherein w is a number of approximately 9.

Example 5

A sample was synthesized in the same manner as described in Example 4 except that the mixing amount of powdery CaO and CuO was varied to prepare a mixture having the composition: $Tl_{0.64}Pb_{0.2}Bi_{0.16}Sr_2Ca_{2+p}Cu_{2+q}$ and this mixture was used as the starting material for baking. As in the case of Examples 3 and 4, the superconductive characteristics such as resistance-temperature characteristics and magnetization-temperature of the resultant sample were evaluated. The results of these evaluations are shown in Table 4. From the table, the ranges of p and q within which the resistance "0" temperature is higher than 115K are as follows:

$$0<p\leqq 1.5$$
$$0<q\leqq 1.5.$$

Example 6

To investigate the effect of annealing in Example 4, the sintered sample obtained in Example 4 (3) was subjected to heat treatment under various conditions and the superconductive characteristics of the resultant samples are shown in Table 5.

Table 4

| Sampl No. | p | q | Tc* | Magnitude of diamagnetic signal at 5K (based on complete diamagnetism) |
|---|---|---|---|---|
| 1 | 0 | 0 | 90K | 20 % |
| 2 | 0.5 | 0.5 | 115K | 15 % |
| 3 | 1.0 | 1.0 | 120K | 20 % |
| 4 | 1.5 | 1.5 | 117K | 15 % |
| 5 | 2.0 | 2.0 | 100K | 10 % |

* Resistance "0" temperature

Table 5

| Sample No. | Atmosphere | Temperature (C°) | Time (hr) | Tc* (K) | Magnitude of diamagnetic signal at 5K (based on complete diamagnetism) |
|---|---|---|---|---|---|
| A | $O_2$ | 600 | 20 | 120 | 20 % |
| B | $N_2$ | 600 | 20 | 119 | 21 % |
| C | Air | 600 | 20 | 118 | 20 % |
| D | $O_2$ | 700 | 20 | 118 | 19 % |
| E | $O_2$ | 400 | 20 | 116 | 18 % |
| F | $O_2$ | 300 | 20 | 114 | 20 % |
| G | $O_2$ | 600 | 0.5 | 113 | 19 % |
| H | $O_2$ | 600 | 1 | 117 | 20 % |
| I | $O_2$ | 600 | 10 | 118 | 21 % |
| J | $O_2$ | 600 | 50 | 119 | 18 % |

* Resistance "0" temperature

Example 7

Commercially available $Tl_2O_3$, PbO, $Bi_2O_3$, $SrCO_3$, $CaCO_3$, CaO and CuO of high purity were used as the starting materials for preparing the sample. First of all, PbO $Bi_2O_3$, $SrCO_3$, $CaCO_3$ and CuO were weighed so as to correspond to the proportion $Pb_{0.25}Bi_{0.15}Sr_2Ca_3Cu_4$ and well mixed. This mixed powder was pressed and calcined at 850°C for 10 hours in oxygen atmosphere. Next, the resultant calcined product was well pulverized and $Tl_2O_3$ was added thereto so that the composition might become $Tl_{0.6}Pb_{0.25}Bi_{0.15}Sr_2Ca_3Cu_4$ and the whole was well mixed. This mixed powder was press molded to form a rectangular parallelopiped of 2 mm × 2mm × 20 mm, sealed in a metal pipe, sintered at 900-950°C for 20 hours in oxygen atmosphere and cooled in a furnace. The sample was annealed at 800°C for 20 hours in oxygen atmosphere. The sample was then taken out from the furnace and measured for its resistance-temperature characteristics according to a usual 4 terminal method.

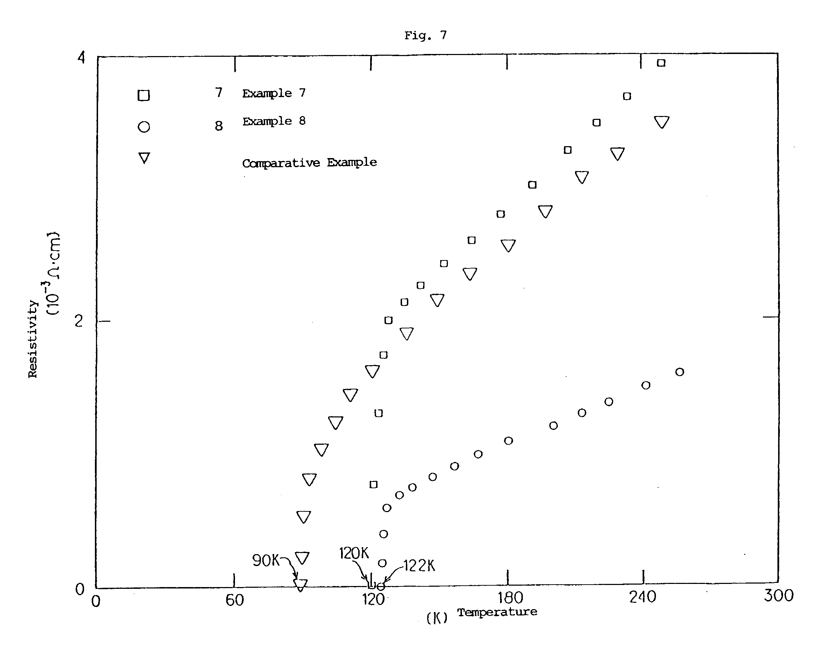

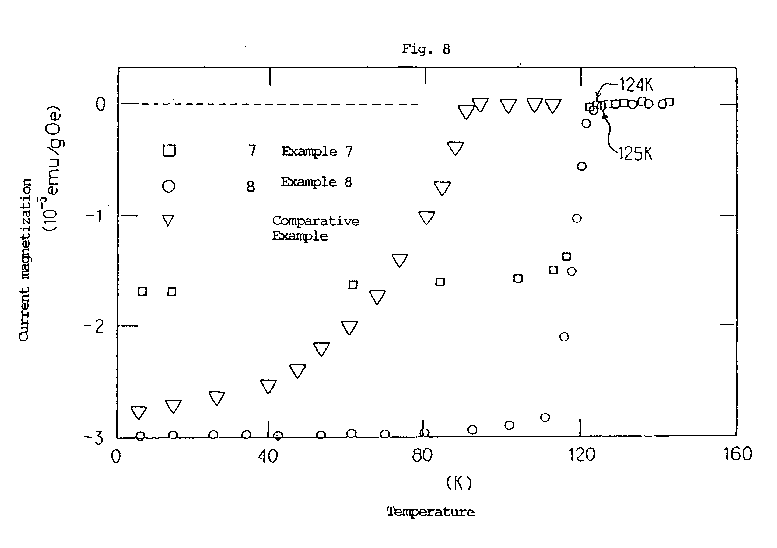

Fig. 7 shows the result of the measurement. The superconductivity initiating temperature of this sample was 125K and its resistance "0" temperature was 120K. Fig. 8 shows the result of the measurement of direct current magnetization of this sample. This sample began to show a diamagnetic signal from 124K. As shown in Fig. 8, the magnitude of the diamagnetic signal was about 12% of the complete diamagnetism at 5K.

A powder X-ray diffraction pattern of the sample produced according to the the above process, measured by the aid of an X-ray diffraction apparatus using Cu-K$\alpha$ rays as a beam source was just like Fig. 6A. From the peaks, it is understood that the sample is a crystalline phase comprised of (Tl,Pb,Bi)-$Sr_2Ca_2Cu_3O_w$ having a lattice constant a = 0.38 nm and c = 1.5 nm with w being a number of approximately 9. For the purpose of comparison, a sample was synthesized according to the above process from a mixture having a composition of $Tl_{0.5}Pb_{0.25}Bi_{0.15}Sr_2Ca_2Cu_3$. The resistance-temperature characteristics and the direct current magnetization of this sample are shown in Figs. 7 and 8, respectively. A powder X-ray diffraction pattern of this sample for comparison is just like Fig.6B. The critical temperature of the sample for comparison was about 90K. In view of the powder X-ray diffraction pattern, it is understood that the produced crystalline phase was not (Tl,Pb,Bi)$Sr_2Ca_2Cu_3O_w$ but a phase of (Tl,Pb,Bi)$Sr_2CaCu_2O_7$. This reveals that the phase (Tl,Pb,Bi)$Sr_2Ca_2Cu_3O_9$ is hardly produced but the phase (Tl,Pb,Bi)$Sr_2CaCu_2O_7$ is easily produced from a mixture having a composition of (Tl,Pb,Bi)$Sr_2Ca_2Cu_3$.

It is understood from the above that the 1223 phase is easily produced from a mixture having the composition to which Ca and Cu are added excessively.

Example 8

The process illustrated in Example 8 is as folows:

(1) As in Example 7, commercially available $Tl_2O_3$, PbO, $Bi_2O_3$, $SrCO_3$, $CaCO_3$, CaO and CuO of high purity were used as the starting materials. First of all, PbO, $Bi_2O_3$, $SrCO_3$, $CaCO_3$ and CuO were weighed so as to correspond to $Pb_{0.25}Bi_{0.15}Sr_2Ca_2Cu_3$ and well mixed. This mixed powder was pressed and calcined at 850 °C for 10 hours in oxygen atmosphere.

(2) The resultant calcined product was well pulverized and $Tl_2O_3$ was added thereto so that the composition might become $Tl_{0.6}Pb_{0.25}Bi_{0.15}Sr_2Ca_2Cu_3$ and the whole was well mixed. This mixed powder was press molded to form a rectangular parallelo-piped of 2 mm × 2 mm × 20 mm, sealed in a metal pipe, sintered at 900-950 °C for 20 hours in oxygen atmosphere and cooled in a furnace.

(3) This sintered material was pulverized again and powdery CaO and CuO were added thereto so that the coposition might become $Tl_{0.6}Pb_{0.25}Bi_{0.15}Sr_2Ca_3Cu_4$, and the whole was well mixed. This mixed powder was again press molded, sealed in a metal pipe and sintered at 920 °C for 10 hours in oxygen atmosphere.

(4) After cooling the furnace, the sample was annealed at 800 °C for 20 hours in oxygen atmosphere.

The sample was then taken out from the furnace and measured for its resistance-temperature characteristics according to a usual 4 terminal method.

Fig. 7 shows the result of the measurement. The superconductivity initiating temperature of this sample was 125K and its resistance "0" temperature was 122K. Fig. 8 shows the result of the treatment of direct current magnetization of this sample. As shown in Fig. 8, the sample began to show a diamagnetic signal from 125K. The magnitude of the diamagnetic signal was about 20 % of the complete diamagnetism at 5K.

In comparison of the characteristics of the sample in Example 8 with those of the sample in Example 7, the sample of Example 8 is higher in the resistance "0" temperature by 2K. In case of the direct current magnetization, no significant difference is found between them in the temperature at which diamagnetism is initiated. However, the sample in Example 8 is about 2 times as much as the sample in Example 7 in the magnitude of the diamagnetic signal at 5K.

As is evident from the peak of X-ray diffraction pattern, it is noted that the superconductive oxide material in Example 8 has a phase of (Tl,Pb,Bi)$Sr_2Ca_2Cu_3O_w$ similar to the sample in Example 7 wherein w is a number of approximately 9.

Example 9

A sample was synthesized in the same manner as described in Example 8 except that the mixing amount of powdery CaO and CuO was varied to prepare a mixture having the composition: $Tl_{0.6}Pb_{0.25}Bi_{0.15}Sr_2Ca_{2+p}Cu_{2+q}$ and this mixture was used as the starting material for baking. As in the case of Examples 7 and 8, the superconductive characteristics such as resistance-temperature characteristics and magnetization-temperature characteristic of the resultant sample were evaluated. The result of these evaluations is shown in Table 6. From the table, the ranges of p and q within which the resistance "0" temperature is higher than 115K are as follows:

$$0<p\leqq 1.5$$
$$0<q\leqq 1.5$$

Exmple 10

To investigate the effect of annealing in Example 8, the sintered sample obtained in Example 8 (3) was subjected to heat treatment under various conditions and the superconductive characteristics of the resultant samples are shown in Table 7.

Table 6

| Sample No. | p | q | Tc* | Magnitude of diamagnetic signal at 5K (based on complete diamagnetism) |
|---|---|---|---|---|
| 1 | 0 | 0 | 90K | 20 % |
| 2 | 0.5 | 0.5 | 117K | 17 % |
| 3 | 1.0 | 1.0 | 122K | 23 % |
| 4 | 1.5 | 1.5 | 119K | 17 % |
| 5 | 2.0 | 2.0 | 100K | 10 % |

* Resistance "0" temperature

Table 7

| Sample No. | Atmosphere | Temperature (C°) | Time (hr) | Tc* (K) | Magnitude of diamagnetic signal at 5K (based on complete diamagnetism) |
|---|---|---|---|---|---|
| A | $O_2$ | 600 | 20 | 118 | 20 % |
| B | $O_2$ | 700 | 20 | 120 | 19 % |
| C | $O_2$ | 800 | 20 | 122 | 23 % |
| D | $O_2$ | 900 | 20 | 120 | 17 % |
| E | $O_2$ | 950 | 20 | 115 | 10 % |
| F | $N_2$ | 800 | 20 | 121 | 21 % |
| G | Air | 800 | 20 | 120 | 20 % |

* Resistance "0" temperature

Example 11

Powders of $Tl_2O_3$, $Bi_2O_3$, PbO, $SrCO_3$, $CaO_3$ and CuO having a purity of at least 99 % were used as the starting materials.

First of all, $SrCO_3$, $CaCO_3$ and CuO were mixed so that the atomic ratio might correspond to Sr:Ca:Cu = 2:3:4, and the mixture was calcined. Given amounts of $Tl_2O_3$, $Bi_2O_3$ and PbO were added to the resultant calcined powder, and the whole was mixed to prepare mixtures having the compositions (1)-(24) as shown in Fig. 8. The mixture were molded and then calcined to prepare three samples.

Namely, $SrCO_3$, $CaCO_3$ and PbO weighed so as to make a given composition were pulverized and mixed in a vibrating mill using $ZrO_2$ balls of 2 mm in diameter together with 40 ml of ethanol as dispersion medium. After completion of the mixing, the total weight of the mixture including the dispersion medium was dried at 120°C in a drier. The resultant powder was calcined at 860°C for 24 hours in the air. After adding given amount of $Tl_2O_3$, $Bi_2O_3$ and PbO to the powder, the whole was pulverized and mixed in a vibrating mill for 30 minutes in the same manner as described above and the mixture was dried at 120°C. In a metal die of 15 mm x 5 mm, 0.4 g of this powder was one-roll pressure molded under a pressure of 500 kg/cm$^2$. This molded article was wrapped with a gold foil, sealed in a quartz tubl under reduced pressure, and baked in an electric furnace to prepare a sample. The velocity of elevating the temperature was 400°C in each sample.

The composition of the sample thus obtained was (Tl + Bi + Pb):Sr:Ca:Cu = 1:2:3:4.

Silver electrodes were then fitted to the sintered sample and the change of electric resistance by temperature was measured according to a usual four terminal method whereby the resistance was measured from 300k to 15K with a measuring electric surrent of 10 mA to obtain an electric resistance depression initiating temperature ($T_1$) at which the electric resistance is suddenly depressed by superconductive transition and an electric resistance disappearing temperature ($T_2$) at which the electric resistance becomes zero. The sintered sampel was further measured for the change of magnetization by te perature to obtain a Meisner effect initiating temperature ($T_3$) at which the magnetization begins to change suddenly by Meisner effect. The result of these measurements is shown in the following table:

Table 8 (1)

| Sample No. | Composition No. | Calcination | | Transition temperature (K) | | |
|---|---|---|---|---|---|---|
| | | Temp. (C°) | Time (Hr) | T1 | T2 | T3 |
| 1 | 1 | 905 | 0.25 | 120 | 115 | 23 |
| 2 | 1 | 905 | 1 | 117 | 104 | 116 |
| 3 | 1 | 905 | 4 | 113 | 81 | 83 |
| 4 | 1 | 905 | 16 | 90 | 26 | 23 |
| 5 | 2 | 905 | 0.25 | 120 | 115 | 121 |
| 6 | 2 | 905 | 16 | 122 | 114 | 120 |
| 7 | 3 | 905 | 16 | 122 | 114 | 119 |
| 8 | 4 | 905 | 0.25 | 121 | 114 | 119 |
| 9 | 4 | 905 | 16 | 89 | 43 | 50 |
| 10 | 5 | 905 | 0.25 | 121 | 116 | 120 |
| 11 | 5 | 904 | 16 | 124 | 121 | 120 |
| 12 | 6 | 904 | 16 | 123 | 120 | 120 |
| 13 | 7 | 905 | 0.25 | 123 | 111 | 122 |
| 14 | 7 | 905 | 16 | 90 | 34 | 34 |
| 15 | 8 | 905 | 0.25 | 121 | 109 | 122 |
| 16 | 8 | 905 | 16 | 78 | 32 | 53 |
| 17 | 9 | 905 | 0.25 | 123 | 116 | 122 |
| 18 | 9 | 905 | 16 | 123 | 120 | 120 |
| 19 | 10 | 905 | 0.25 | 120 | 112 | 120 |
| 20 | 10 | 905 | 16 | 69 | 42 | 47 |
| 21 | 11 | 905 | 0.25 | 121 | 113 | 122 |

Table 8 (2)

| Sample No. | Composition No. | Calcination | | Transition temperature (K) | | |
|---|---|---|---|---|---|---|
| | | Temp. (C°) | Time (Hr) | T1 | T2 | T3 |
| 22 | 11 | 905 | 16 | 122 | 117 | 120 |
| 23 | 12 | 905 | 0.25 | 123 | 117 | 122 |
| 24 | 12 | 905 | 16 | 124 | 116 | 117 |
| 25 | 13 | 910 | 16 | 125 | 121 | 121 |
| 26 | 14 | 910 | 0.25 | 120 | 111 | 117 |
| 27 | 14 | 910 | 16 | 121 | 113 | 116 |
| 28 | 15 | 910 | 0.25 | 112 | 90 | 70 |
| 29 | 15 | 910 | 16 | 110 | 83 | 76 |
| 30 | 16 | 910 | 16 | 108 | 65 | 70 |
| 31 | 17 | 895 | 0.25 | 122 | 118 | 119 |
| 32 | 17 | 895 | 16 | 123 | 119 | 120 |
| 33 | 18 | 895 | 16 | 124 | 121 | 120 |
| 34 | 19 | 895 | 16 | 121 | 100 | 90 |
| 35 | 20 | 900 | 16 | 123 | 120 | 120 |
| 36 | 21 | 895 | 16 | 123 | 119 | 120 |
| 37 | 22 | 895 | 16 | 120 | 99 | 116 |
| 38 | 23 | 895 | 16 | 123 | 115 | 120 |
| 39 | 24 | 895 | 16 | 120 | 88 | 111 |

As is evident from Table 8, the samples free of Bi (Nos. 1, 4, 7, 8 and 10) undergo evaporation of Tl by making the calcination time longer so that the superconductivity transition initiating temperature ($T_1$) is significantly depressed. By adding Bi, however, the evaporation of Tl is inhibited even when calcination is carried out for a longer time so that a higher superconductivity transition initiating temperature ($T_1$) can be maintained. As calcination for a longer time is possible, not only is broadened the range for the optimum calcination condition but also it is advantageous for enhancing homogeneity of the samples. A superconductivity transition initiating temperature ($T_1$) is obtained also in case of replacing Tl by Pb so that the amount of harmful Tl can be minimized.

The sintered samples are pulverized and subjected to X-ray diffraction analysis whereby a diffraction pattern having a sharp peak at $2\theta = 4.6$ was observed in the samples of the composition $(Tl_{1-x-y}Bi_xPb_y)_1Sr_2Ca_3Cu_4O_z$ wherein x, y, and z are in the range of $0.05 \leqq x \leqq 0.55$, $0 \leqq y \leqq 0.55$ and $x + y \leqq 0.65$. It is considered from the above that a crystalline phase represented by the chemical composition $(Tl_{1-x-y}Bi_xPb_y)_1Sr_2Ca_3Cu_4O_z$ is formed.

Particles having a periodic structure of 19.2A corresponding to a peak at $2\theta = 4.6$ in the X-ray diffraction pattern were observed by a transition type electron microscope and the composition of that portion was analyzed by the aid of an X-ray micro-analyzer whereby it was confirmed that the elements Tl, Bi, Pb, Sr, Ca and Cu existed in the range shown in the above composition.

## Claims

1. A superconductive material characterized by having a crystalline phase comprised of oxides of the chemical composition:

$Tl_xPb_yBi_zSr_2Ca_2Cu_3O_r$

wherein x, y, z are numbers satisfying the following formulae:

$$x + y + z = 1$$
$$0.3 \leqq x \leqq 0.95$$
$$0 \leqq y \leqq 0.5$$
$$0.05 \leqq z \leqq 0.4$$

and r is a number of approximately 9.

2. A superconductive material characterized by having a crystalline phase comprised of oxides of the chemical composition:

$Tl_xPb_yBi_zSr_2Ca_2Cu_3O_r$

wherein x, y, z are numbers satisfying the following formulae:

$$x + y + z = 1$$
$$0.35 \leqq x \leqq 0.9$$
$$0 \leqq y \leqq 0.45$$
$$0.05 \leqq z \leqq 0.2$$

and r is a number of approximately 9.

3. A superconductive material characterized by having a crystalline phase comprised of oxides of the chemical composition:

$Tl_xPb_yBi_zSr_2Ca_2Cu_3O_r$

wherein x, y, z are numbers satisfying the following formulas:

$$x + y + z = 1$$
$$0.35 \leqq x \leqq 0.9$$
$$0 \leqq y \leqq 0.4$$
$$x/z = 4/1$$

and r is a number of approximately 9.

4. A superconductive material having a crystalline phase comprised of oxides of the chemical composition:

$(Tl_{1-x-y}Bi_xPb_y)_1Sr_2Ca_3Cu_4O_z$

wherein x and y are numbers satisfying the following formula:

$$0.05 \leqq x \leqq 0.55$$
$$0 \leqq y \leqq 0.55$$
$$x + y \leqq 0.65$$

and z is any desired number.

5. A process for the production of a superconductive material having a crystalline phase comprised of oxides of the chemical composition:

$Tl_xPb_yBi_zSr_2Ca_2Cu_3O_r$

wherein x, y, z are numbers satisfying the following formulae:

$$x+y+z = 1$$
$$0.3 \leqq x \leqq 0.95$$
$$0 \leqq y \leqq 0.5$$
$$0.05 \leqq z \leqq 0.4$$

and r is a number of approximately 9, characterized in that a mixture containing at least Tl, Bi, Sr, Ca, Cu and O and, if necessary, Pb wherein the atomic ratio of Tl:Pb:Bi:Sr:Ca:Cu: is x:y:z:2:2:3 where x, y and z have the same meanings as given above, is baked in oxygen atmosphere.

6. A process for the production of a superconductive material according to claim 5 , wherein the partial pressure in the oxygen atmosphere is at least $1.013 \times 10^5$ Pa (1 atm.).

7. A process for the production of a superconductive material according to claim 5 or 6 , wherein x, y and z in the chemical composition are numbers satisfying the following formulae;

$$x+y+z = 1$$
$$0.35 \leqq x \leqq 0.9$$
$$0 \leqq y \leqq 0.45$$
$$0.05 \leqq z \leqq 0.2$$

8. A process for the production of a superconductive material according to claim 7 , wherein y is a number satisfying the formula: $0 \leqq y \leqq 0.4$ and the ratio of x to z is 4:1.

9. A process for the production of a superconductive material having a crystalline phase comprised of oxides of the chemical composition:

$Tl_xPb_yBi_zSr_2Ca_2Cu_3O_r$

wherein x, y, z are numbers satisfying the following formulae:

$$x+y+z = 1$$
$$0.3 \leqq x \leqq 0.95$$
$$0 \leqq y \leqq 0.5$$
$$0.05 \leqq z \leqq 0.4$$

and r is a number of approximately 9, characterized in that a mixture containing at least Tl, Bi, Sr, Ca, Cu and O, and if necessary Pb, wherein the atomic ratio of Tl:Pb:Bi:Sr:Ca:Cu: is x:y:z:2+p:3+q where x, y and z have the same meanings as given above, p and q are numbers satisfying the formulae: $0 < p \leqq 1.5$ and $0 < q \leqq 1.5$, respectively, is baked at 900-950 °C and thereafter annealing the resultant baked product for a least one hour at a temperature of 400-900 °C.

10. A process for the production of a superconductive material according to claim 9 , wherein x, y and z in the chemical composition are numbers satisfying the following formulae:

$$x+y+z = 1$$
$$0.35 \leqq x \leqq 0.9$$
$$0 \leqq y \leqq 0.45$$
$$0.05 \leqq z \leqq 0.2.$$

11. A process for the production of a superconductive material according to claim 7 , wherein y is a number satisfying the formula: $0 \leqq y \leqq 0.4$ and the ratio of x to z is 4:1.

## Patentansprüche

1. Supraleitendes Material, dadurch gekennzeichnet, daß es eine kristalline Phase aus Oxiden mit folgender chemischer Zusammensetzung besitzt:

   $Tl_xPb_yBi_zSr_2Ca_2Cu_3O_r$

   worin x, y und z Zahlen sind, die folgenden Formeln entsprechen:

   $$x + y + z = 1$$
   $$0{,}3 \leqq x \leqq 0{,}95$$
   $$0 \leqq y \leqq 0{,}5$$
   $$0{,}05 \leqq z \leqq 0{,}4$$

   und r eine Zahl von etwa 9 ist.

2. Supraleitendes Material, dadurch gekennzeichnet, daß es eine kristalline Phase aus Oxiden mit folgender chemischer Zusammensetzung besitzt:

   $Tl_xPb_yBi_zSr_2Ca_2Cu_3O_r$

   worin x, y und z Zahlen sind, die folgenden Formeln entsprechen:

   $$x + y + z = 1$$
   $$0{,}35 \leqq x \leqq 0{,}9$$
   $$0 \leqq y \leqq 0{,}45$$
   $$0{,}05 \leqq z \leqq 0{,}2$$

   und r eine Zahl von etwa 9 ist.

3. Supraleitendes Material, dadurch gekennzeichnet, daß es eine kristalline Phase aus Oxiden mit folgender chemischer Zusammensetzung besitzt:

   $Tl_xPb_yBi_zSr_2Ca_2Cu_3O_r$

   worin x, y und z Zahlen sind, die folgenden Formeln entsprechen:

   $$x + y + z = 1$$
   $$0{,}35 \leqq x \leqq 0{,}9$$
   $$0 \leqq y \leqq 0{,}4$$
   $$x/z = 4/1$$

   und r eine Zahl von etwa 9 ist.

4. Supraleitendes Material mit einer kristallinen Phase aus Oxiden mit folgender chemischer Zusammensetzung:

   $(Tl_{1-x-y}Bi_xPb_y)_1Sr_2Ca_3Cu_4O_z$

   worin x und y Zahlen sind, die folgenden Formeln entsprechen:

   $$0{,}05 \leqq x \leqq 0{,}55$$
   $$0 \leqq y \leqq 0{,}55$$
   $$x + y \leqq 0{,}65$$

   und z jede gewünschte Zahl ist.

5. Verfahren zur Herstellung eines supraleitenden Materials mit einer kristallinen Phase aus Oxiden mit folgender chemischer Zusammensetzung:

$Tl_xPb_yBi_zSr_2Ca_2Cu_3O_r$

worin x, y und z Zahlen sind, die folgenden Formeln entsprechen:

$$x + y + z = 1$$
$$0{,}3 \leqq x \leqq 0{,}95$$
$$0 \leqq y \leqq 0{,}5$$
$$0{,}05 \leqq z \leqq 0{,}4$$

notwendig, Pb, wobei das Atomverhältnis von Tl:Pb:Bi:Sr:Ca:Cu x:y:z:2:2:3 beträgt, worin x, y und z die gleichen Bedeutungen, wie oben angegeben, haben, in einer Sauerstoffatmosphäre gebrannt wird.

6. Verfahren zur Herstellung eines supraleitenden Materials gemäß Anspruch 5, dadurch gekennzeichnet, daß der Partialdruck in der Sauerstoffatmosphäre wenigstens $1{,}013 \times 10^5$ Pa (1 atm) beträgt.

7. Verfahren zur Herstellung eines supraleitenden Materials gemäß Anspruch 5 oder 6, dadurch gekennzeichnet, daß x, y und z in der chemischen Zusammensetzung Zahlen sind, die folgenden Formeln entsprechen:

$$x + y + z = 1$$
$$0{,}35 \leqq x \leqq 0{,}9$$
$$0 \leqq y \leqq 0{,}45$$
$$0{,}05 \leqq z \leqq 0{,}2$$

8. Verfahren zur Herstellung eines supraleitenden Materials gemäß Anspruch 7, dadurch gekennzeichnet, daß y eine Zahl ist, die der Formel $0 \leqq y \leqq 0{,}4$ entspricht, und das Verhältnis von x zu z 4:1 beträgt.

9. Verfahren zur Herstellung eines supraleitenden Materials mit einer kristallinen Phase aus Oxiden mit folgender chemischer Zusammensetzung:

$Tl_xPb_yBi_zSr_2Ca_2Cu_3O_r$

worin x, y und z Zahlen sind, die folgenden Formeln entsprechen:

$$x + y + z = 1$$
$$0{,}3 \leqq x \leqq 0{,}95$$
$$0 \leqq y \leqq 0{,}5$$
$$0{,}05 \leqq z \leqq 0{,}4$$

und r eine Zahl von etwa 9 ist, dadurch gekennzeichnet, daß ein Gemisch aus wenigstens Tl, Bi, Sr, Ca, Cu und O und, falls notwendig, Pb, wobei das Atomverhältnis von Tl:Pb:Bi:Sr:Ca:Cu x:y:z:2:2+p:3+q beträgt, worin x, y und z die gleichen Bedeutungen, wie oben angegeben, haben, und p und q Zahlen sind, die den Formeln $0 < p \leqq 1{,}5$ bzw. $0 < q \leqq 1{,}5$ entsprechen, bei 900 - 950 °C gebrannt und anschließend das dabei entstehende gebrannte Produkt wenigstens 1 h bei einer Temperatur von 400 - 900 °C getempert wird.

10. Verfahren zur Herstellung eines supraleitenden Materials gemäß Anspruch 9, dadurch gekennzeichnet, daß x, y und z in der chemischen Zusammensetzung Zahlen sind, die folgenden Formeln entsprechen:

$$x + y + z = 1$$
$$0{,}35 \leqq x \leqq 0{,}9$$
$$0 \leqq y \leqq 0{,}45$$
$$0{,}05 \leqq z \leqq 0{,}2$$

11. Verfahren zur Herstellung eines supraleitenden Materials gemäß Anspruch 7, dadurch gekennzeichnet, daß y eine Zahl ist, die der Formel $0 \leqq y \leqq 0,4$ entspricht, und das Verhältnis von x zu z 4:1 beträgt.

## Revendications

1. Matériau supraconducteur caractérisé en ce qu'il a une phase cristalline composée d'oxydes de la composition chimique suivante :

   $Tl_xPb_yBi_zSr_2Ca_2Cu_3O_r$

   où x, y et z sont des nombres satisfaisant aux formules suivantes :

   $$x + y + Z = 1$$
   $$0,3 \leqq x \leqq 0,95$$
   $$0 \leqq y \leqq 0,5$$
   $$0,05 \leqq z\ 0,4$$

   et r est un nombre environ égal à 9.

2. Matériau supraconducteur caractérisé en ce qu'il a une phase cristalline composée d'oxydes de la composition chimique suivante :

   $Tl_xPb_yBi_zSr_2Ca_2Cu_3O_r$

   où x, y et z sont des nombres satisfaisant aux formules suivantes :

   $$x + y + z = 1$$
   $$0,35 \leqq x \leqq 0,9$$
   $$0 \leqq y \leqq 0,45$$
   $$0,05 \leqq z\ 0,2$$

   et r est un nombre environ égal à 9.

3. Matériau supraconducteur caractérisé en ce qu'il a une phase cristalline composée d'oxydes de la composition chimique suivante :

   $Tl_xPb_yBi_zSr_2Ca_2Cu_3O_r$

   où x, y et z sont des nombres satisfaisant aux formules suivantes :

   $$x + y + z = 1$$
   $$0,35 \leqq x \leqq 0,9$$
   $$0 \leqq y \leqq 0,4$$
   $$x/z = 4/1$$

   et r est un nombre environ égal à 9.

4. Matériau supraconducteur ayant une phase cristalline composée d'oxydes de la composition chimique suivante :

   $(Tl_{1-x-y}Bi_xPb_y)_1Sr_2Ca_3Cu_4O_z$

   caractérisé en ce que x et y sont des nombres satisfaisant aux formules suivantes :

   $$0,05 \leqq x \leqq 0,55$$
   $$0 \leqq y \leqq 0,55$$
   $$x + y \leqq 0,65$$

et z est un nombre quelconque.

**5.** Procédé de production d'un matériau supraconducteur ayant une phase cristalline composée d'oxydes de la composition chimique suivante :

$Tl_xPb_yBi_zSr_2Ca_2Cu_3O_r$

où x, y et z sont des nombres satisfaisant aux formules suivantes :

$$x + y + z = 1$$
$$0,3 \leqq x \leqq 0,95$$
$$0 \leqq y \leqq 0,5$$
$$0,05 \leqq z \leqq 0,4$$

et r est un nombre environ égal à 9, caractérisé en ce qu'un mélange contenant au moins du Tl, Bi, Sr, Ca, Cy et O, et, si nécessaire, du Pb, où le rapport atomique de Tl : Pb : Bi : Sr : Ca : Cu est de x : y : z : 2 : 2 : 3 où x, y et z sont conformes aux valeurs ci-dessus, est cuit dans une atmosphère d'oxygène.

**6.** Procédé de production d'un matériau supraconducteur selon la revendication 5, caractérisé en ce que la pression partielle de l'atmosphère d'oxygène est d'au moins $1,013 \times 10^5$ Pa (1 atmosphère).

**7.** Procédé de production d'un matériau supraconducteur selon la revendication 5 ou la revendication 6, caractérisé en ce que x, y et z dans la composition chimique sont des nombres satisfaisant aux formules suivantes :

$$x + y + z = 1$$
$$0,35 \leqq x \leqq 0,9$$
$$0 \leqq y \leqq 0,45$$
$$0,05 \leqq z \leqq 0,2$$

**8.** Procédé de production d'un matériau supraconducteur selon la revendication 7, caractérisé en ce que y est un nombre satisfaisant à la formule $0 \leqq y \leqq 0,4$ et en ce que le rapport de x à z et de 4 : 1.

**9.** Procédé de production d'un matériau supraconducteur ayant une phase cristalline composée d'oxydes de la composition chimique suivante :

$Tl_xPb_yBi_zSr_2Ca_2Cu_3O_r$

où x, y et z sont des nombres satisfaisant aux formules suivantes :

$$x + y + z = 1$$
$$0,3 \leqq x \leqq 0,95$$
$$0 \leqq y \leqq 0,5$$
$$0,05 \leqq z \leqq 0,4$$

et r est un nombre environ égal à 9, caractérisé en ce qu'un mélange contenant au moins du Tl, Bi, Sr, Ca, Cy et O, et, si nécessaire, du Pb, où le rapport atomique de Tl : Pb : Bi : Sr : Ca : Cu est de x : y : z : 2 : 2+p : 3+q où x, y et z sont conformes aux valeurs ci-dessus et p et q sont des nombres satisfaisant aux formules $0 < p \leqq 1,5$ et $0 < q \leqq 1,5$ respectivement, est cuit à entre 900 et 950 °C suivi d'un recuit du produit cuit qui en résulte pendant au moins une heure à une température allant de 400 à 900 °C.

**10.** Procédé de production d'un matériau supraconducteur selon la revendication 9, caractérise en ce que x, y et z dans la composition chimique sont des nombres satisfaisant aux formules suivantes :

$$x + y + z = 1$$

$$0{,}35 \leqq x \leqq 0{,}9$$
$$0 \leqq y \leqq 0{,}45$$
$$0{,}05 \leqq z \leqq 0{,}2.$$

**11.** Procédé de production d'un matériau supraconducteur selon la revendication 7, caractérisé en ce que y est un nombre satisfaisant à la formule $0 \leqq y \leqq 0{,}4$ et en ce que le rapport entre x et z est de 4 : 1.

Fig. 1

Onset temperature
123K
Mid point temperature
120K
Zero resistance temperature
118K
0
50
100
150
200
250
300
Temperature
(K)
0
3
6
Resistivity
(10-3 ohm-cm)

Fig. 2

Measured at cooling process
H = 10 Oe
0
-1
-2
-3
-4
-5
50
100
122
150
(K)
Temperature
$(10^{-3}$ emu/g)
Current magnetization

Fig. 3

Diffraction peak of the phase of tetragonal system of
a = 0.382 nm, c = 1.53 nm
Strength (cps)
8000
6000
4000
2000
0
10
20
30
40
(001)
(002)
(003)
(004)
(101)
(102)
(103)
(110)
(104)
(111)
(006)
(105)
(007)
(115)
(200)
(008)

Fig. 4

3 Example 3
4 Example 4
Comparative Example
118K
120K
90K
0
60
120
180
240
300
(K) Temperature
4
2
Resistivity
(10⁻³Ω.cm)

Fig. 5

3 Example 3
4 Example 4
Comparative Example
90K
123K
122K
0
40
80
120
160
Temperature (K)
0
1
2
3
Current magnetization (10⁻³emu/g)

Fig. 6A

Peak of 1 2 2 3 phase
5 10 15 20 25 30 35 40 45 50 55 60
2θ

Fig. 6B

Peak of 1 2 1 2 phase
5 10 15 20 25 30 35 40 45 50 55 60
2θ

Fig. 6C

Peak of 1 2 2 3 phase
5 10 15 20 25 30 35 40 45 50 55 60

Fig. 7

Example 7
Example 8
Comparative Example
Resistivity
($10^{-3}$ Ω·cm)
(K) Temperature
0
2
4
60
120
180
240
300
90K
120K
122K

Example 7
Example 8
Comparative Example
124K
125K
0
-1
-2
-3
0
40
80
120
160
(K)
Temperature
Current magnetization
(10-3 emu/gOe)

Fig. 8

Tl
Pb
Bi
1-x-y
y
x

Fig. 9